Europäisches Patentamt

European Patent Office

Office européen des brevets

(11) Veröffentlichungsnummer: **0 481 108 A1**

## (12) EUROPÄISCHE PATENTANMELDUNG

(21) Anmeldenummer: **90119795.4**

(22) Anmeldetag: **16.10.90**

(51) Int. Cl.5: **H01L 39/02**, H01L 39/24

(43) Veröffentlichungstag der Anmeldung:
**22.04.92 Patentblatt 92/17**

(84) Benannte Vertragsstaaten:
**DE FR GB IT SE**

(71) Anmelder: **kabelmetal electro GmbH
Kabelkamp 20 Postfach 260
W-3000 Hannover 1(DE)**
(84) **DE**

(71) Anmelder: **ALCATEL N.V.
Strawinskylaan 341 (World Trade Center)
NL-1077 XX Amsterdam(NL)**
(84) **FR GB IT SE**

(72) Erfinder: **Madry, Peter, Dipl.-Ing.
Nienstedter Stadtweg 7F
W-3013 Barsinghausen(DE)**

(74) Vertreter: **Mende, Eberhard, Dipl.-Ing. et al
kabelmetal electro GmbH Gewerblicher
Rechtsschutz Kabelkamp 20 Postfach 260
W-3000 Hannover 1(DE)**

(54) Verfahren zur Herstellung einer supraleitfähigen Verbindungsstelle.

(57) Zur Herstellung einer supraleitfähigen Verbindungsstelle zwischen wenigstens zwei Supraleitern aus auf langgestreckten Trägern angeordneten Schichten eines Hochtemperatur-Supraleiters auf Basis keramischer Mischoxide werden an der Verbindungsstelle zunächst die beiderseitigen Täger von der supraleitfähigen Schicht befreit und deren Enden durchverbunden und anschließend werden auf die Verbindungsstelle der beidseitigen Träger keramische Mischoxide zur supraleitenden Verbindung der beiderseitigen Hochtemperatur-Supraleiter aufgetragen.

EP 0 481 108 A1

Die vorliegende Erfindung betrifft ein Verfahren zur Herstellung einer supraleitfähigen Verbindungsstelle zwischen wenigstens zwei Supraleitern aus auf langgestreckten Trägern angeordneten Schichten eines Hochtemperatur-Supraleiters auf Basis keramischer Mischoxide.

Möglichkeiten zur Verbindung supraleitfähiger Leiterstränge sind seit langem bekannt. So hat man bereits in solchen Fällen, bei denen der Supraleiter aus einer Vielzahl von supraleitfähigen Einzelelementen besteht, die äußere, normalleitende Umhüllung dieser Einzelelemente aus Kupfer oder einem anderen geeigneten Material entfernt und anschließend die beiderseitigen Enden der Einzelelemente durch eine supraleitfähige Klemmhülse elektrisch leitend miteinander verbunden (EP 0 137 170 A2). Abgesehen davon, daß bei dieser auf den ersten Blick recht einfachen Verbindung supraleitfähiger Elemente eine Verbindung der jeweiligen Enden nicht unmittelbar, sondern lediglich über die allen gemeinsame supraleitfähige Preßhülse erfolgt, ist das Verfahren nicht anwendbar für die in neuerer Zeit entwickelten sogenannten Hochtemperatur-Supraleiter, bei denen die Supraleitfähigkeit, nicht wie bei der bekannten Anordnung über mechanisch stabile Niob-Zinn-Verbindungen erfolgt, sondern auf gegenüber Druck und Zug empfindlichen Supraleitschichten aus keramischen Mischoxiden.

Zur Verbindung supraleitfähiger Leiterstränge sind aber auch schon andere Vorrichtungen und Verfahren bekannt geworden (EP 0 077 539 B1). Hier werden als Möglichkeiten bekannte Kaltpreß-Schweißverfahren erwähnt, Ultraschall-Schweißverfahren oder sogenannte Explosions-Schweißverfahren, bei denen die Leiterenden mit Hilfe von Sprengladungen explosionsverschweißt werden. Aber auch ein sogenanntes Punktschweißen wird ebenso erwähnt wie sogenannte Diffusionsverbindungen oder andere Verfahren, bei denen die Enden von zwei supraleitenden Drähten zunächst mit einer supraleitenden Wismut-Blei-Zinn-Verbindung umhüllt und innerhalb einer supraleitenden Hülse in Kontakt gebracht werden. Um einen guten Kontakt zwischen Hülse und supraleitenden Drähten herzustellen, wird anschließend die gesamte Anordnung verpreßt. Diese bekannten Verfahren betreffen alle Supraleiter auf der Basis $Nb_3Sn$, bei denen eine hinreichende mechanische Stabilität der Supraleiter solche Schweiß- und Preßverbindungen ohne Schädigung der supraleitfähigen Schicht zuläßt.

Bekannt ist es aber auch, an der Verbindungsstelle die supraleitenden Schichten der Supraleiter von Belägen zu befreien, die supraleitenden Schichten zur Überlappung zu bringen und supraleitende Zwischenschichten mittels chemischer Abscheidung aus der Gasphase zur Kontaktierung auf die supraleitenden Schichten aufzubringen. Auch dieses bekannte Verfahren geht davon aus, daß die supraleitenden Schichten selbsttragend und ausreichend stabil sind, um so, wie beschrieben, gehandhabt zu werden, d. h. auch hierbei wird von den bekannten Supraleitern auf Basis $Nb_3Sn$ ausgegangen.

Von diesem Stand der Technik geht die Erfindung aus, ihr liegt die Aufgabe zugrunde, eine Möglichkeit zu finden, auch bei den neuentwickelten Supraleitern auf Basis keramischer Mischoxide betriebssichere Verbindungen zwischen den Enden von Supraleitern zu schaffen, die einfach gehandhabt und deshalb auch problemlos, beispielsweise an einem verlegten Kabel, durchgeführt werden können.

Diese Aufgabe wird gemäß der Erfindung dadurch gelöst, daß an der Verbindungsstelle zunächst die beiderseitigen Träger von der supraleitfähigen Schicht befreit und deren Enden durchverbunden werden, und daß anschließend auf die Verbindungsstelle der beiderseitigen Träger keramische Mischoxide zur supraleitenden Verbindung der beiderseitigen Hochtemperatur-Supraleiter aufgetragen werden. Die mechanische Verbindung der Träger, die an den Enden frei von Mischoxiden sind, läßt sich mit heute üblichen Verfahren problemlos durchführen, die mechanische Stabilität solcher Verbindungen steht außer Frage. Der nachträgliche Auftrag der keramischen Mischoxide kann sowohl hinsichtlich der Dicke der aufzutragenden Schicht sowie der Zusammensetzung den jeweiligen Gegebenheiten problemlos angepaßt werden.

Wie bereits ausgeführt, betrifft die vorliegende Erfindung solche Supraleiter, deren Sprungtemperatur bei 100 K und darüber liegt, und die im wesentlichen aus den Mischoxiden Yttrium, Barium, aus Kupfer und Sauerstoff bestehen und unter dem Begriff keramische Werkstoffe Eingang in die Technik gefunden haben. Diese Mischoxide werden z. B. in pulverförmigem Zustand auf einen Träger aufgebracht und anschließend durch eine geeignete Temperaturbehandlung gesintert und in den supraleitenden Zustand überführt. In Weiterbildung der Erfindung hat es sich deshalb zur Herstellung der supraleitfähigen Verbindungsstelle als zweckmäßig erwiesen, die keramischen Mischoxide durch Reibschweißen aufzubringen. Unter diesem Begriff ist ein bekanntes Verfahren zu verstehen, bei dem eines der zu verbindenden Teile in Rotation versetzt, während das andere, stillstehende Werkstück gegen das sich drehende Werkstück gepreßt wird. Die hierbei wirkenden Reib-und Druckkräfte führen zu einer erheblichen Erwärmung der zu verbindenden Elemente und einer Verbindung innerhalb nur weniger Sekunden. Zur Durchführung dieses Verfahrens liegt beispielsweise der keramische Werkstoff in fester Form als Preßkörper vor, etwa als gesinterter Strang, als Tablettten oder dergl.. Eine andere Möglichkeit zur Durchführung des erfindungsgemäßen Verfahrens ist die, die keramischen Mischoxide in Pulverform durch Flamm- oder Plasmaspritzen auf die bereits mechanisch sicher verbundenen Träger im Bereich der Verbindungsstelle aufzubringen. Dabei werden die Teilchen in der Flamme erhitzt und unter hohem Druck auf die zu beschichtenden Werkstoffflächen geschleudert. Eine Verschweißung mit dem Trägerwerkstoff ist die Folge.

Das erfindungsgemäße Verfahren ist für supraleitfähige Leiterstränge in beliebiger Form und Abmessung anwendbar. So können nach diesem Verfahren supraleitfähige Bänder und Folien ebenso problemlos miteinander verbunden werden, wie Drähte oder sonstige Profile. Aber auch die Verbindung solcher Elemente ist möglich, bei denen die supraleitfähige Schicht auf einem rohrförmigen Träger, innen oder außen, angeordnet ist, sogar wenn dieser Träger aus einem gewellten Metallrohr hergestellt ist.

Handelt es sich bei den zu verbindenden supraleitenden Strängen um eine Vielzahl von Filamenten, d. h. Trägerkörpern sehr kleinen Durchmessers, die aber in großer Anzahl vorhanden sind, beispielsweise um den Leitquerschnitt eines Kabels aufzuteilen, dann wird man in Weiterführung des Erfindungsgedankens zweckmäßig so vorgehen, daß nach dem Entfernen der supraleitfähigen Schichten deren Träger in gebündelter Form miteinander verbunden werden. An dieser Verbindungsstelle wird dann die supraleitfähige Schicht für alle Trägerelemente gemeinsam aufgebracht. Unabhängig davon, welchem Verfahren der Vorzug gegeben wird, wird es oft vorteilhaft sein, nach dem Aufbringen der keramischen Mischoxide eine Temperaturbehandlung, ggf. unter Schutzgas, an der Verbindungsstelle vorzunehmen.

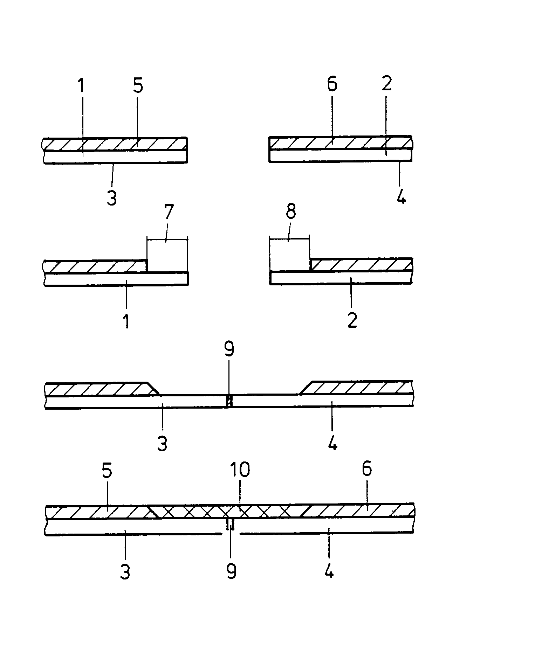

Die Erfindung sei anhand des in der Figur dargestellten Ausführungsbeispieles näher erläutert.

Die beiderseitigen Enden zweier nicht näher dargestellter Supraleiterelemente sind mit 1 und 2 bezeichnet, sie bestehen jeweils aus einem Träger 3 bzw. 4 und einer darauf aufgebrachten supraleitfähigen Schicht 5 bzw. 6 aus einem supraleitfähigen Mischoxid. Solche Mischoxide, d. h. keramische Werkstoffe, enthalten mindestens eines der Elemente Kupfer, Blei oder Wismut. Für die weitere Zusammensetzung der supraleitfähigen Schicht ist mindestens eines der Elemente der Gruppen 2 und 3 des periodischen Systems wesentlich. Aus der Gruppe 2 sind es vor allem das Strontium (Sr) und das Barium (Ba), die in Kombination mit Elementen der Gruppe 3, wie Yttrium (Y) und Lanthan (La) bereits zu hohen Sprungtemperaturen geführt haben.

Zur Herstellung einer supraleitfähigen Verbindungsstelle zwischen den Leitern 1 und 2 wird nun, wie weiter dargestellt, in den Bereichen 7 und 8 der Leiterenden 1 und 2 die supraleitfähige Mischoxidschicht 5 bzw. 6 entfernt, beispielsweise durch Abschleifen oder Abschmirgeln. Anschließend erfolgt eine mechanische Verbindung der beiderseitigen Träger 3 und 4 der Supraleiter, beispielsweise metallurgisch durch eine Schweißverbindung 9. Nachdem die Träger 3 und 4 mechanisch sicher verbunden worden sind, wird an dem von den supraleitfähigen Schichten zunächst befreiten Bereich der Verbindungsstelle das supraleitfähige Mischoxid in Form der Beschichtung 10 aufgebracht. Das Aufbringen dieser Beschichtung 10 kann beispielsweise mittels eines für die Bearbeitung von keramischen Werkstoffen bekannten Reibschweiß-Verfahrens erfolgen, wobei die einzelnen Mischoxidteilchen kurzfristig auf hohe Temperaturen erwärmt und nach Art eines Sintervorganges fest mit den darunter liegenden Trägerschichten verbunden werden. Falls erforderlich, kann anschließend noch eine Temperaturbehandlung zum Zwecke einer abschließenden Sinterung und Erzielung der Supraleitfähigkeit vorgenommen werden.

## Patentansprüche

1.  Verfahren zur Herstellung einer supraleitfähigen Verbindungsstelle zwischen wenigstens zwei Supraleitern aus auf langgestreckten Trägern angeordneten Schichten eines Hochtemperatur-Supraleiters auf Basis keramischer Mischoxide, dadurch gekennzeichnet, daß an der Verbindungsstelle zunächst die beiderseitigen Träger von der supraleitfähigen Schicht befreit und deren Enden durchverbunden werden, und daß anschließlich auf die Verbindungsstelle der beidseitigen Träger keramische Mischoxide zur supraleitenden Verbindung der beiderseitigen Hochtemperatur-Supraleiter aufgetragen werden.

2.  Verfahren nach Anspruch 1, dadurch gekennzeichnet, daß die keramischen Mischoxide durch Reibschweißen aufgetragen werden.

3.  Verfahren nach Anspruch 1, dadurch gekennzeichnet, daß die keramischen Mischoxide durch Flamm- oder Plasmaspritzen aufgebracht werden.

4.  Verfahren nach Anspruch 1 oder einem der folgenden, bei dem eine Vielzahl Supraleiter miteinander zu verbinden sind, dadurch gekennzeichnet, daß nach dem Entfernen der supraleitfähigen Schichten deren Träger in gebündelter Form miteinander verbunden werden.

5. Verfahren nach Anspruch 1 oder einem der folgenden, dadurch gekennzeichnet, daß nach dem Aufbringen der keramischen Mischoxide eine Temperaturbehandlung, gegebenenfalls unter geeignetem Schutzgas, erfolgt.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | EP-A-0 390 517 (NGK INSULATORS)<br>* Spalte 10, Zeilen 7-58; Figuren 2B,4B *<br>– – – | 1,3 | H 01 L 39/02<br>H 01 L 39/24 |
| X | PATENT ABSTRACTS OF JAPAN, Band 140, Nr. 95 (E-892), 21. Februar 1990;<br>& JP-A-1 302 676 (FUJIKURA)<br>* Ganze Zusammenfassung *<br>– – – – – | 1,3 | |

RECHERCHIERTE
SACHGEBIETE (Int. Cl.5)

H 01 L 39

Der vorliegende Recherchenbericht wurde für alle Patentansprüche erstellt

| Recherchenort | Abschlußdatum der Recherche | Prüfer |
|---|---|---|
| Den Haag | 22 Mai 91 | HAMMEL E.J. |